# EUROPEAN PATENT SPECIFICATION

(11) **EP 4 354 103 B1**
(45) Date of publication and mention of the grant of the patent: **02.12.2026**
(21) Application number: 22201324.5
(22) Date of filing: 13.10.2022
(51) Int. Cl.: G01K 1/143, G01K 1/14, H10W 40/00, H10W 72/00, H10W 72/50

(54) **ELECTRONIC DEVICE COMPRISING A SENSOR UNIT AND METHOD FOR MOUNTING A SENSOR ELEMENT**
ELEKTRONISCHES GERÄT MIT EINER SENSOREINHEIT UND VERFAHREN ZUR MONTAGE EINES SENSORELEMENTS.
DISPOSITIF ÉLECTRONIQUE COMPRENANT UNE UNITÉ DE CAPTEUR ET PROCÉDÉ DE MONTAGE D'UN ÉLÉMENT DE CAPTEUR.

(43) Date of publication of application: 17.04.2024
(73) Proprietor: Hitachi Energy Ltd, 8050 Zürich (CH)
(72) Inventor: PAQUES, Gontran, 5600 Lenzburg (CH); SANTOLARIA, Lluis, 5600 Lenzburg (CH); TRUESSEL, Dominik, 5620 Bremgarten (CH); EHRBAR, Roman, 8037 Zürich (CH); ROESCH, Andreas, 79730 Murg (DE)
(74) Representative: Epping - Hermann - Fischer

(56) References cited:
- WO-A1-2018/016162
- WO-A1-2021/151949
- JP-A- 2018 107 243

## Description

The present disclosure relates to an electronic device comprising a sensor unit and to a method for mounting a sensor element.

WO 2018/016162 A1 discloses a temperature sensor positioned on a flexible substrate and placed on a semiconductor element. JP 2018 107243 A discloses a temperature sensor which is pressed against a switch element with the help of a screw and a flexible plate.

WO 2021/151949 A1 discloses a power semiconductor module in which a contact temperature sensor is positioned in thermal contact with a metal clip. The contact temperature sensor is connected to pins of a circuit board, which press the sensor against the metal clip.

It is an object of the present invention to provide an improved electronic device with a sensor unit, for example a sensor unit which can be easily and securely mounted to an electronic device. Another object is to provide an improved method for mounting a sensor element, for example a method which uses the above-mentioned sensor unit for mounting the sensor element.

Embodiments of the disclosure relate to an improved electronic device with a sensor unit and an improved method for mounting a sensor element.

According to an embodiment, the electronic device comprises a sensor unit that comprises a sensor element for measuring a physical quantity in the electronic device and a contact element which is configured to be mechanically biased. The contact element is fixed to the sensor element and electrically connected thereto. The electronic device comprises a member having a measurement surface at which a physical quantity is to be measured with the help of the sensor element, wherein the sensor element is placed on the measurement surface. The contact element is mechanically biased in order to exert a force onto the sensor element acting in the direction towards the measurement surface. The electronic device comprises a resin body, wherein, to maintain the biased state, the contact element is fixed to the resin body or the contact element is connected to an auxiliary terminal structure or to a circuit board which is fixed to the resin body.

Such a sensor unit can be easily mounted to the electronic device, like a power semiconductor module, even if the electronic device was originally developed without such a sensor element. The contact element, which can be biased in order to exert a force onto the sensor element, enables the sensor element to be securely placed onto the measurement surface without using any additional connection means, like solder or adhesive. Instead, the biased contact element presses the contact element towards or against the measurement surface and thereby may also enable a secure dry electrical contact to be formed between the sensor element and the measurement surface. In order to maintain the biased state of the contact element, structures which are present in the electronic device anyway, like the auxiliary terminal structure and the resin body, can be used to fix a portion of the contact element thereto.

The sensor element is, for example, a transducer (measurand transducer) and as such the part of a measuring device that responds directly to a measurand. Thus, the sensor element may be the first element of a measuring chain. The sensor element is, for example, configured to detect a physical quantity, like temperature, humidity, pressure, acceleration etc., and, as a response to that, generates or manipulates an electric signal which can be read out via the contact element.

The contact element is at least partially electrically conductive. The contact element may comprise a contact region which is a region distant from, particularly opposite to, the sensor element and at which the contact element can be electrically connected. The contact element provides an electrically conductive path from the sensor element to the contact region. In this way, it might be enabled to read-out the sensor element with the help of the contact element, particularly to receive electrical signals from the sensor element via the contact element or to supply electrical signals to the sensor element via the contact element. Thus, the contact element may also be used to supply the sensor element with voltage and/or current.

The contact element may be formed in one piece or may consist of several parts. For example, the contact element is made of metal or comprises metal. That the contact element is configured to be mechanically biased means that at least a portion/section of the contact element is elastic and deformable in order to bring the contact element from a relaxed state of the contact element into a biased state of the contact element. In the biased state, the contact element tends to automatically return into the relaxed state. The at least one elastic portion of the contact element is, for example, reversibly deformable. The contact element may comprise one or more deformable, elastic portions/sections like springs. When bringing the contact element from the relaxed state into the biased state, the at least one elastic or deformable portion is compressed and/or bended and/or deflected, for example. Mechanically biased and mechanically stressed are used as synonyms.

The contact element is mechanically fixed to the sensor element. This means that the contact element and the sensor element form a composite. The connection between the contact element and the sensor element may be a form-fitting and/or force-fitting and/or material-locking (bond) connection. For example, this connection is not non-destructively detachable. When mounting the sensor unit, it is mounted with the composite of the sensor element and the contact element. That is, the contact element and the sensor element are not mounted separately.

When the sensor unit is mounted to the member of the electronic device, the sensor element, e.g. a bottom side thereof, can be placed on the measurement surface of the member. The bottom side of the sensor element is, for example, a side of the sensor element opposite to the side where the connection between the contact element and the sensor element is established. Thus, the mounted sensor element may be arranged between the measurement surface and at least a portion of the contact element. The measurement surface of the member is herein meant to be a surface at which the physical quantity is to be measured with the help of the sensor element.

When mounting the sensor unit, the contact element is mechanically biased, i.e. brought into the biased state, as a consequence of which it exerts a force onto the sensor element towards the measurement surface. By way of example, the sensor unit is configured such that when taking the sensor unit by holding and/or fixing it at a certain region of the contact element, e.g. at an end region thereof, then placing the sensor element onto the measurement surface and then trying to press the sensor element further towards the measurement surface, the contact element is mechanically biased, i.e. the at least one deformable portion of the contact element is deformed.

If the contact element is then fixed relative to the member with the measurement surface such that the biased state is maintained, the sensor element will be securely positioned onto the measurement surface without the need of a material-locking connection between the sensor element and the measurement surface. For example, the connection between the sensor element and the measurement surface is then only of form-fitting and/or force-fitting nature.

For example, the contact element, when biased, is configured to exert a force onto the sensor element which is at least 0.01 N or at least 0.1 N.

According to a further embodiment, the sensor element is a temperature sensor. For example, the sensor element is a temperature sensitive resistor, also called "thermistor". The sensor element may be an NTC, PTC, a platinum resistor, like a PT100 or PT1000, or a thermocouple. Alternatively, the sensor element may be a humidity sensor, an acceleration sensor or a pressure sensor.

Indeed, there is strong customer interest for the temperature supervision of, for example, power semiconductor devices (herein also called "power semiconductor chips" or simply "chips") or power semiconductor modules during operation. The temperature supervision is typically used for protection against overheating of the chips, for example in situations of overcurrent, or for monitoring of the degradation state of the power semiconductor module with respect to the aging of, for example, joining connections, which in turn has an impact on the thermal resistance and consequently on the chip temperature.

According to at least one embodiment, the contact element comprises or is one of: a spring contact element or a press contact pin. A spring contact element has, for example, a meander-shaped region and/or a V-shaped region and/or a U-shaped region and/or a spring washer region and/or spring region which can be compressed in order to bring the contact element into the biased state. Additionally or alternatively, a spring contact element can have a cantilever shaped portion which can be bended in order to bring the spring contact element into the biased state. A spring contact element may be formed in one piece.

A press contact pin comprises, for example, a main body, e.g. a barrel or tubular body/sleeve, a tip element, e.g. a plunger, and one or more springs, like spiral spring(s), which can be compressed in order to bring the contact element into the biased state. The tip element is movably mounted with respect to the main body and can be moved towards or further into the main body by compressing the spring. A press contact pin is, for example, an elongated element. The tip element of the press contact pin may be fixed to the sensor element.

According to a further embodiment, the contact element is fixed to the sensor element by means of a material-locking connection or bond connection, respectively. Also the electrical connection may be established by the material-locking connection. For example, the contact element is soldered, sintered or glued to the sensor element or the fixed connection is realized by any other applicable joining method.

According to a further embodiment, the contact element comprises means for screwing the contact element into a thread of the electronic device, e.g. a threaded hole of an auxiliary terminal. For example, the contact element comprises an outer thread. Alternatively, however, also other means for fixing the contact element to the electronic device are conceivable, like a profiling or ribs at an outer surface of the contact element which can be embedded into the resin body in order to form-fittingly fix the contact element to the electronic device.

According to a further embodiment, the contact element comprises a terminal region, wherein said terminal region is configured to be electrically connected. When mounted in the electronic device, the terminal region may be exposed in order to enable it to be externally electrically contacted. The terminal region is, for example, formed by an end of the contact element distant from and/or opposite to the sensor element, **e.g.** by the above-mentioned contact region. For example, the terminal region is formed by the longitudinal end of the press-contact pin opposite to the pin element.

According to a further embodiment, the contact element comprises a terminal structure. The terminal region may be part of the terminal structure. The terminal structure is, for example, connected to the spring contact or the press contact pin of the contact element. The terminal structure may be a sheet-like structure or a hollow cylinder with screwed thread, like a nut. It may be formed of metal. When mounted in the electronic device, the sheet-like structure may extend substantially parallel to a main extension plane of the electronic device. For example, the terminal structure extends obliquely or perpendicularly to the main extension direction of the press contact pin.

For example, the spring contact or the press contact pin of the contact element is connected to the terminal structure by means of soldering, welding, crimping, gluing or screwing. Alternatively, the spring contact or the press contact pin may be formed in one piece with the terminal structure.

According to a further embodiment, the sensor element comprises a top electrode at a top side of the sensor element. Additionally, the sensor element may comprise a bottom electrode at a bottom side of the sensor element, wherein the bottom side is opposite to the top side.

The top electrode and the bottom electrode are, for example, metallic areas of the sensor element. They are configured to electrically connect the sensor element for read-out and/or to supply current and/or voltage to the sensor element.

According to a further embodiment, the contact element is electrically connected and fixed to the top electrode of the sensor element.

According to a further embodiment, the bottom electrode of the sensor element, particularly a side thereof facing away from the top electrode, is exposed in an unmounted configuration of the sensor unit. That is, in the unmounted configuration, the bottom electrode is freely accessible. For example, when mounted to the measurement surface, a (dry) electrical contact is formed between the bottom electrode and the measurement surface so that the sensor element can be read out via the measurement surface on the one hand, and via the contact element on the other hand.

The electronic device described herein may be, for example, a power semiconductor module or an assembly comprising a power semiconductor module.

The sensor element may be placed directly on the measurement surface, i.e. may adjoin the measurement surface. At least a thermal contact between the measurement surface and the sensor element may be formed in this way.

The contact element is fixed in the electronic device such that it is maintained in its biased state. For example, the contact element is fixed such that a movement of the contact element or any portion thereof in a direction away from the measurement surface in order to get into the relaxed state is prevented. On the other hand, movement of the sensor element in direction towards the measurement surface in order to get into the relaxed state is also prevented because the sensor element is placed on the measurement surface. The biased contact element may press the sensor element against the measurement surface. In this way a reliable contact between measurement surface and the sensor element may be realized. A loss of the contact between sensor element and measurement surface may be prevented. Also a lateral movement of the sensor element is made difficult.

According to a further embodiment, the sensor element is placed on the measurement surface or the respective member, respectively, without a material-locking connection (bond) between them and connecting them. For example, the sensor element can be non-destructively detached from the measurement surface. By way of example, the sensor element is connected to the measurement surface purely by a force-fitting and/or form-fitting connection. A non-material-locking connection between two elements is also called "dry connection".

The sensor element may be electrically connected to the measurement surface or the member, respectively. An electrical contact between two elements which is established without a material-locking connection, i.e. by a dry connection, is herein called "dry electrical contact". For example, the electrical contact between the measurement surface and the sensor element is exclusively provided by a dry electrical contact.

According to a further embodiment, the electronic device comprises a power semiconductor device. By way of example, the power semiconductor device is a switching device. The power semiconductor device may be an IGBT or a MOSFET or a HEMT or a diode or a thyristor. In this case, the electronic device is or comprises, for example, a power semiconductor module having one or more power semiconductor devices.

The power semiconductor module may comprise a substrate with a top metallization and, optionally, with a bottom metallization. The at least one power semiconductor device may be mounted on the top side of the substrate where the top metallization is located, e.g. it may be mounted on the top metallization. The substrate may be a DBC (direct bonded copper) substrate or a DBA (direct bonded aluminum) substrate or an AMB (active metal bracing) substrate with an isolating ceramic layer or an IMS (isolated metal substrate) with an isolating resin layer, for example. Furthermore, the power semiconductor module may comprise terminals (main terminals and, optionally, auxiliary terminals) for external electrical connection. The terminals may be realized by terminal structures, which are, for example, sheet-like and/or of metal and/or formed in one piece. Other shapes of the terminals, like hollow cylinders with screwed threads, like nuts, are possible. Terminal regions of the terminal structures are exposed in order to enable external electrical contact. The terminal structures may be bonded to the top metallization or may be realized by the top metallization. Terminals can also directly connect chips, but also control electronics.

The power semiconductor module may further comprise a housing body. The housing body may be formed of an electrically isolating material, like a resin and/or gel. The power semiconductor device(s) may be embedded in the housing body. The terminal structures may be at least partially embedded in the housing body. The terminal regions of the terminal structures may project out of the housing body, e.g. at lateral sides thereof. The housing body may comprise a housing frame surrounding a cavity. The cavity may be filled with the gel.

Moreover, the power semiconductor module may comprise a baseplate. The baseplate is, for example, intended for cooling. The substrate may be mounted on the baseplate, e.g. with the bottom metallization facing the baseplate. The baseplate may be made of metal, like Cu or Al or an alloy thereof, or of a composite material like aluminum silicon carbide or magnesium silicon carbide. The baseplate may comprise cooling structures like pin fins or ribs at a side facing away from the substrate.

Herein, a lateral direction is a direction parallel to the main extension plane of the substrate. A vertical direction is a direction perpendicular to the main extension plane of the substrate.

According to a further embodiment, the sensor element is placed on the power semiconductor device.

According to a further embodiment, the sensor element is placed in a region next to the power semiconductor device. For example, the sensor element is placed on the top metallization of the substrate next to the power semiconductor device and/or between two adjacent power semiconductor devices. The top metallization may then form the measurement surface.

The placement of the sensor element on the power semiconductor device has some advantages over placing the sensor element on the substrate next to the power semiconductor device or even on a separate substrate of the electronic device next to the substrate on which the power semiconductor device is mounted. For example, the quality of the determination of the chip temperature improves with the reduced distance between the chip and the temperature sensor. Indeed, in this case, the true temperature of the chip can be derived more accurately from the sensor reading using a thermal model. Moreover, a time delay of the temperature change and the corresponding measurement caused by a large distance can be clearly reduced when the sensor element is placed directly on the chip.

A further advantage of placing the sensor element on the power semiconductor device is that, if more than one heat generating chip is mounted on the substrate, the sensor reading refers mainly to one chip and not to an average of the chips. When the sensor element is placed between the chips on the substrate, the measured temperature is possibly not referring to the temperature of the thermally most disadvantageous or most degraded chip. In the worst case, strong degradation of the joining connection under one chip is not detected.

Further, when the sensor element is placed on the chip, it can be avoided that, due to a degraded die bond not conducting the heat, a too high temperature of the chip is not detected.

Also, the placement of the sensor element on the top metallization next to the power semiconductor device consumes space on the substrate surface, which reduces the available space for chips. This may also have a negative impact on the thermal resistance and consequently on the rated costs per ampere.

Moreover, many products were originally developed without integration of a sensor element. As a consequence, there may be no area on the substrate available for the placement of the sensor element. However, meanwhile, there is a strong trend in customer requests towards implementation of thermal sensors.

The electronic device may comprise several of the above-specified sensor units. For example, several power semiconductor devices are each assigned such a sensor unit with the sensor element thereof mounted on the respective power semiconductor device. It is also possible that one or more sensor elements of one or more sensor units are mounted on the top metallization of one or more substrates next to or in between the power semiconductor device(s) and one or more sensor elements of one or more sensor units are mounted on one or more power semiconductor devices. For example, there may be one such sensor unit per substrate.

According to a further embodiment, the measurement surface is formed by a top electrode of the power semiconductor device. The top electrode of the power semiconductor device may be, for example, a source/emitter electrode or a drain/collector electrode. The top electrode may be made of metal, like Cu or Al or corresponding alloy.

According to a further embodiment, the bottom electrode of the sensor element is in dry electrical contact with the top electrode of the power semiconductor device. The contact between the bottom electrode of the sensor element and the top electrode of the power semiconductor device may additionally be a thermal contact.

Also in the case that the sensor element is mounted on the top metallization of the substrate, there may be a dry electrical contact between the bottom electrode of the sensor element and the measurement surface (top metallization).

The sensor reading of the sensor element is, for example, between the contact element and an output terminal (e.g. AC terminal) of the electronic device. Alternatively, the sensor reading may be between the contact element and an input terminal (e.g. DC+ or DC- terminal) of the electronic device.

According to a further embodiment, the contact element is electrically and mechanically connected to an auxiliary terminal of the electronic device. The auxiliary terminal is, for example, formed by an auxiliary terminal structure of the electronic device. The auxiliary terminal structure is, for example, a sheet-like metal element or a nut or a hollow (metal) cylinder. The auxiliary terminal(s) is(are) different from the main or power terminals of the electronic device. The main terminals may be AC, DC- and DC+ terminals. Particularly, the auxiliary terminals are configured to carry less current than the main terminals. The auxiliary terminals may be partially embedded into the housing body of the electronic device. The auxiliary terminals may be terminals for control of the power semiconductor device, like for measurements/detection. They may be aux-emitter or aux-collector terminals or gate terminals or terminals connecting sensors.

According to a further embodiment, the contact element is electrically and mechanically connected to the auxiliary terminal by means of a threaded connection. Alternatively, other connections, like soldering, welding, crimping or gluing are possible.

The auxiliary terminal is, for example, a terminal of the electronic device which is externally electrically connectable. That is, a terminal region of the auxiliary terminal is exposed and freely accessible. For example, the terminal region of the auxiliary terminal is exposed and/or projects out of the housing body at the lateral side thereof. Alternatively, the auxiliary terminal may be exposed and/or project out of the housing body at a top side thereof, e.g. when the auxiliary terminal is a nut, a vertical pin, or a hollow sleeve.

According to a further embodiment, a thermally conductive material is arranged between the measurement surface and the sensor element. The thermally conductive material may be a paste filled with particulates, e.g. electrically conductive particles. The thermally conductive material may be electrically conductive or electrically isolating. The paste is liquid and/or viscous. Alternatively, the thermally conductive material may be a heat conductive sheet (e.g. an elastic sheet).

According to a further embodiment, the electronic device comprises at least one, i.e. one or more, power semiconductor modules and a cooler for the power semiconductor module. The cooler may be a carrier for the power semiconductor modules. The cooler is, for example, configured to guide a cooling liquid therethrough. The cooler may comprise a cooling channel for the cooling liquid. The cooler may be made of metal, like copper or aluminum. The power semiconductor module may be mounted on the cooler with the bottom metallization and/or the baseplate facing the cooler.

According to a further embodiment, the measurement surface is formed by the cooler, e.g. by a top surface thereof. The sensor element may then be used to measure the temperature of the cooler. A dry electrical contact may be formed between the cooler and the sensor element.

According to a further embodiment, the measurement surface is formed by the surface of the baseplate. The sensor element may then be placed next to a substrate or between two neighbored substrates, which are mounted on the baseplate.

According to a further embodiment, at least one of the measurement surface and the surface of the sensor element facing the measurement surface is roughened, particularly in order to increase the contact surface. The roughened surface may imprint into the adjoining surface and may therefore increase in the contact surface. Additionally, in this way, a form-fitting connection may be established. Moreover, an undesired oxide layer may be destroyed in this way or impurities/contaminations on the adjoining surface may be penetrated.

According to a further embodiment, the roughened surface has an average roughness of at least 1 µm or at least 1.6 µm or at least 2 µm.

Next, the method for mounting a sensor element is specified. The electronic device according to any of the embodiments described herein may be produced with the help of this method. Therefore, all features disclosed for the electronic device are also disclosed for the method and vice versa.

According to an embodiment, the method for mounting a sensor element comprises a step of providing a sensor unit according to any one of the embodiments described herein. In a further step, a member for an electronic device is provided. The member has a measurement surface at which a physical quantity of the electronic device is to be measured with the help of the sensor element. In a further step, the sensor unit is mounted to the member. The mounting of the sensor unit comprises a step of placing the sensor element onto the measurement surface. The mounting also comprises a step of mechanically biasing the contact element in such a way that it exerts a force onto the sensor element acting in a direction towards the measurement surface. Moreover, mounting comprises a step of fixing at least a portion of the mechanically biased contact element with respect to the member so that the contact element remains in the mechanically biased state. The electronic device comprises a resin body, wherein, to maintain the biased state, the contact element is fixed to the resin body or the contact element is connected to an auxiliary terminal structure or to a circuit board which is fixed to the resin body.

The member may be, for example, a power semiconductor device, a substrate or a top metallization of the substrate, a baseplate or a cooler. Accordingly, the measurement surface may be a top electrode of the power semiconductor device or the top metallization of the substrate or a surface of the baseplate or a surface of the cooler.

The step of placing the sensor element may be performed before or after biasing the contact element. The sensor element may be placed directly on the measurement surface so that it adjoins the measurement surface. The sensor element is, for example, fixed or connected to the measurement surface exclusively by a form-fitting and/or force-fitting connection, i.e. without a material-locking connection formed between them (i.e. a dry connection is formed). Thus, the sensor element is, for example, neither glued nor soldered nor sintered nor welded to the measurement surface. When the sensor element is placed onto the measurement surface, a dry electrical contact may be established between the sensor element and the measurement surface. The biased sensor element may press the sensor element against the measurement surface.

The contact element is, for example, fixed with respect to the member so that the fixed and biased contact element continues to exert a force onto the sensor element in the direction towards the measurement surface. For example, at least a portion of the contact element being distant to the sensor element is fixed with respect to the member.

According to a further embodiment, fixing at least a portion of the mechanically biased contact element with respect to the member comprises screwing the contact element into a thread of the electronic device. Additionally or alternatively, fixing may comprise soldering, sintering, welding, gluing or crimping the contact element to a member of the electronic device.

After placing the sensor element on the measurement surface, a casting process may be performed in which, for example, different members of the electronic device, like power semiconductor devices, are casted into a casting material, which could be a gel. The contact element may be fixed with respect to the member with the measurement surface with the help of the casting process.

Hereinafter, the sensor unit for an electronic device, the electronic device and the method for mounting a sensor element will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. In so far as elements or components correspond to one another in terms of their function in different figures, the description thereof is not repeated for each of the following figures. For the sake of clarity, elements might not appear with corresponding reference symbols in all figures.

Figures 1 to 4 show different positions in an exemplary embodiment of the method for mounting a sensor element as well as an exemplary embodiment of the electronic device (Fig. 4),

Figures 5 to 7 show different positions in a further exemplary embodiment of the method as well as a further exemplary embodiment of the electronic device (Fig. 7),

Figures 8 to 10 show different positions in a further exemplary embodiment of the method as well as a further exemplary embodiments of the electronic device (Fig. 10),

Figures 11 and 12 show different positions in a further exemplary embodiment of the method as well as a further exemplary embodiment of the electronic device,

Figures 13 and 14 show further non-claimed examples of the electronic device,

Figures 15 to 17 show different positions in a further exemplary embodiment of the method as well as a further exemplary embodiment of the electronic device (Fig. 17),

Figures 18 and 19 show further exemplary embodiments of the electronic device.

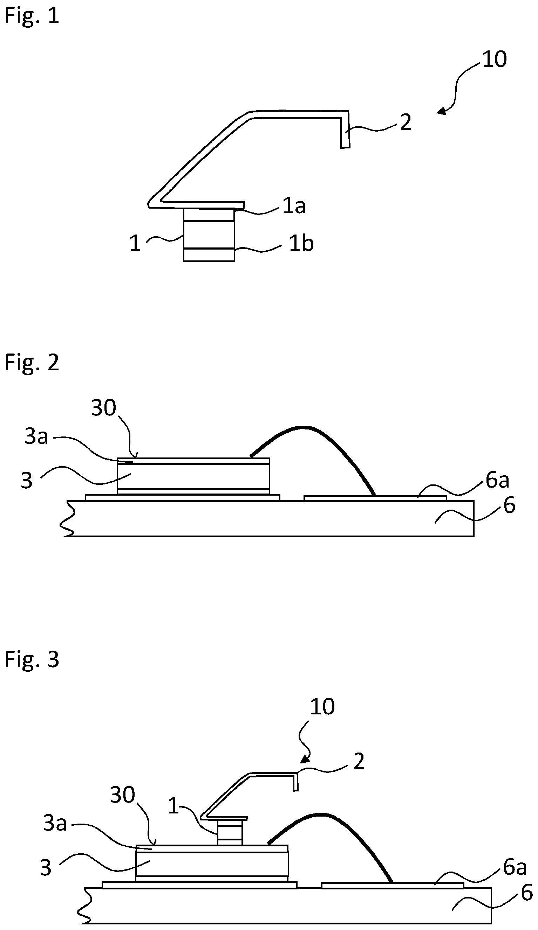

Figure 1 shows a position in which an exemplary embodiment of the sensor unit 10 for an electronic device 100 is provided. The sensor unit 10 comprises a contact element 2 and a sensor element 1. The contact element 2 is a spring contact element which can be mechanically biased by compressing it. The contact element 2 is, for example, formed of metal, like Cu, Al or steel.

The sensor element 1 is, for example, a temperature sensor, like a thermistor. It may be an NTC, PTC or a platinum resistor (e.g. PT100 or PT1000) or a thermocouple. The sensor element 1 comprises a top electrode 1a and a bottom electrode 1b. Both electrodes 1a, 1b may be electrically conductive, particularly metallic. The electrodes 1a, 1b are arranged for reading-out the sensor element 1 but may also serve to supply current and/or voltage to the sensor element 1.

The contact element 2 is fixed to and electrically connected to the sensor element 1, namely to the top electrode 1a thereof. The mechanical and electrical connection between the contact element 2 and the sensor element 1 is, for example, realized by a material-locking connection, e.g. a soldered, sintered, welded or glued connection. Since the contact element 2 is electrically conductive, the sensor element 1 can be read out with the help of the contact element 2.

Figure 2 shows a further position in which an assembly of different members 3, 6 for an electronic device is provided. One member is a substrate 6 having a top metallization 6a. The substrate 6 is, for example, a DBC substrate. A further member is a power semiconductor device 3 mounted on the top side of the substrate 6 and electrically connected thereto via a wire bond. The power semiconductor device 3 comprises a top electrode 3a which constitutes a measurement surface 30 and at which a physical quantity shall be measured with the help of the sensor element 1 of figure 1. By way of example, the power semiconductor device 3 is an IGBT or a power MOSFET with the top electrode 3a being a source or emitter electrode, respectively.

Figure 3 shows a position in which the sensor unit 10 of figure 1 with the composite of the sensor element 1 and the contact element 2 is placed on the power semiconductor device 3 so that the sensor element 1 adjoins the measurement surface 30. No additional connection material for forming a material-locking connection is used between the sensor element 1 and the measurement surface 30. Thus, there is a dry connection between the sensor element 1 and the measurement surface 30.

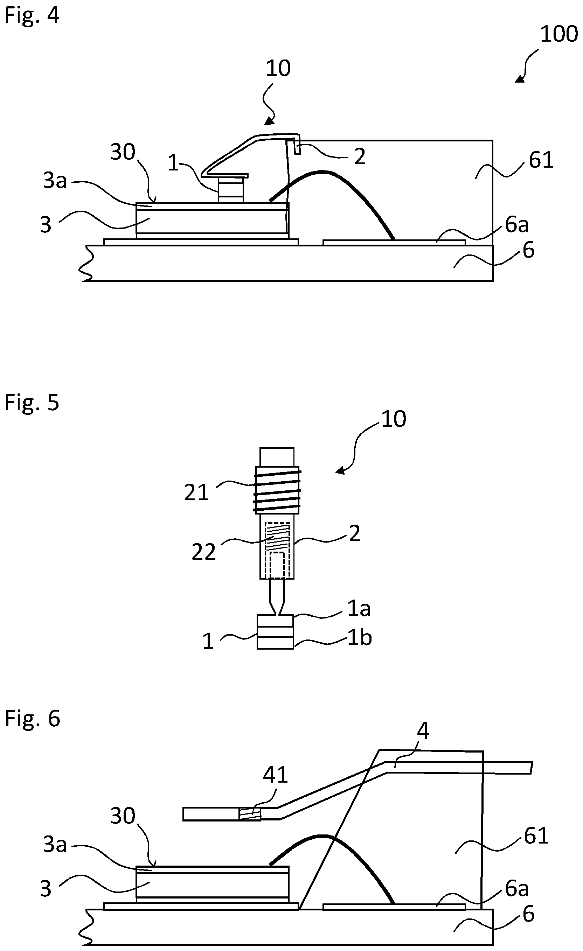

In the position of figure 4, an exemplary embodiment of an electronic device 100 is shown. The electronic device 100 is a power semiconductor module 100. In order to obtain this power semiconductor module 100 from the arrangement of figure 3, the contact element 2 has been compressed or bent and has thus been brought into its biased state. In this biased state, the contact element 2 exerts a force onto the sensor element 1 in the direction towards the measurement surface 30 and thereby presses the sensor element 1 against the measurement surface 30. In this way, the sensor element 1 is securely held on and connected to the measurement surface 30 due to the increased frictional force (dry connection) and a secure and also a reliable electrical connection (dry electrical contact) between the measurement surface 30 and the sensor element 1 is established.

The device of figure 4 may have been produced as follows: In the biased state of the contact element 2, a resin 61 has been applied on the substrate 6 and has encapsulated a part of the contact element 2. After drying the resin 61, the contact element 2 is fixed in its biased state. The resulting resin body 61 forms a housing frame 61 of the power semiconductor module 100. The cavity surrounded by the housing frame may be filled with a gel, for example.

Alternatively, the device of figure 4 may have been produced as follows: a pre-manufactured housing frame 61 could be mounted on the substrate 6 and the contact element 2 could then be clamped in the housing frame 61 so that it stays in the biased state. Alternatively, the contact element 2 may be at least partly embedded into the housing frame 61 as an integral part.

A portion of the contact element 2 at the top side of the power semiconductor module 100 is not covered by the resin body 61 and is exposed. This portion constitutes a terminal region of the contact element 2 for external electrical connection of the contact element 2. Thus, the sensor element 1 can, for example, be read out via the contact element 2 and a DC- or AC terminal of the power semiconductor module 100.

Figure 5 shows a position in which a further exemplary embodiment of the sensor unit 10 is shown. In this case, the contact element 2 is formed by a press contact pin. The press contact pin comprises a spring 22 for pressing a tip element or plunger, respectively, of the press contact pin towards a measurement surface and away from a barrel a hollow sleeve of the press contact pin. The tip element of the press contact pin is mechanically fixed and electrically connected to the sensor element 1 which is, for example, the same sensor element as described before. The mechanical and electrical connection between the tip element and the sensor element 1 may be established in the same way as described before.

The contact element 2 further comprises means 21 for a threaded connection, namely an outer thread 21.

Figure 6 shows a position in which an assembly of different members for an electronic device is provided. This assembly again comprises a substrate 6 and a power semiconductor device 3 mounted thereon. Additionally, the assembly comprises a resin body 61 in which an auxiliary terminal (structure) 4 is partially embedded. The auxiliary terminal structure 4 projects out of the right side of the resin body 61, wherein this projecting part constitutes a terminal region for the external electrical connection of the auxiliary terminal 4.

A further exposed part of the auxiliary terminal structure 4 comprises a through hole with means 41 for a threaded connection, namely an inner thread. The through hole is located vertically above the measurement surface 30 of the power semiconductor device 3.

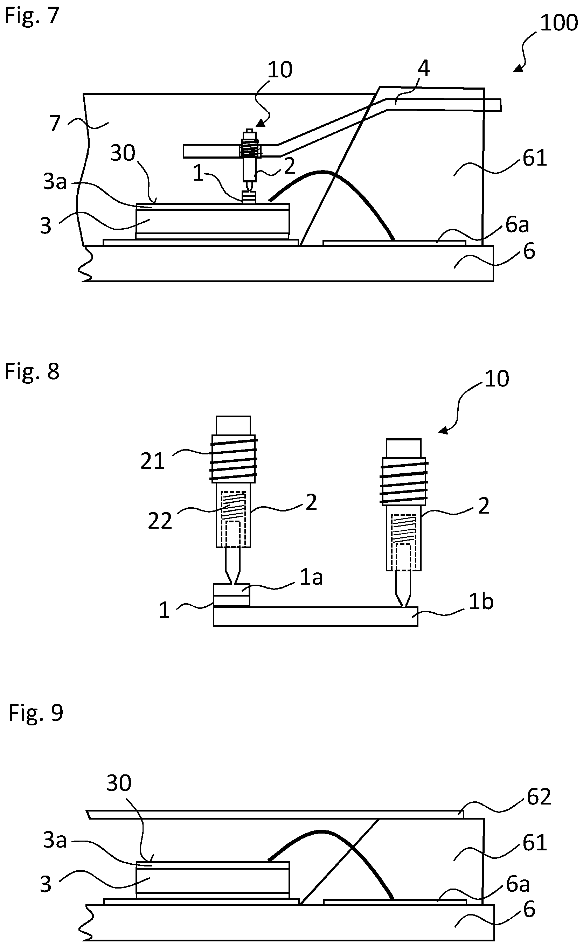

In figure 7, a further exemplary embodiment of the electronic device 100 is shown. Again, the electronic device 100 is a power semiconductor module 100. This power semiconductor module 100 has been obtained by screwing the sensor unit 10 of figure 5 into the through hole of the auxiliary terminal structure 4 of figure 6. Thereby, the sensor element 1 has been placed onto the measurement surface 30. The screwing has further compressed the spring 22 of the contact element 2 so that the contact element 2 has been biased. Consequently, the sensor element 1 is pressed against the measurement surface 30 by the biased contact element 2 and in this way a reliable dry connection and a dry electrical contact is formed between the measurement surface 30 and the sensor element 1. Due to the threaded connection between the auxiliary terminal structure 4 and the contact element 2, the contact element 2 is fixed in position and fixed in its biased state. Afterwards, a casting material 7, e.g. in the form of a gel, has been applied. The casting material 7 and the resin body 61 together form the housing body of the power semiconductor module 100. The sensor element 1 can be read out via the contact element 2 and the auxiliary terminal 4 as well as via a further terminal (e.g. a main terminal electrically connected with the measurement surface of the chip), for example.

In the position of figure 8, a further exemplary embodiment of the sensor unit 10 is provided. In this case, the sensor unit 10 comprises two contact elements 2 each realized as a press contact pin. One contact element 2 is fixed and electrically connected to the top electrode 1a of the sensor element 1 and the other contact element 2 is fixed and electrically connected to the bottom electrode 1b. Thus, the sensor element 1 can be read out via both contact elements 2. In order to enable both the top 1a and the bottom 1b electrode to be contacted with the contact elements 2 from the top side, as shown in figure 8, the bottom electrode 1b projects beyond the top electrode 1a in lateral direction.

Alternatively, the sensor element 1 could comprise two electrodes 1a and 1b at its top side so that also in this case the sensor element 1 could be contacted with the two contact elements 2 from the top side.

Figure 9 shows a position in which again an assembly of several members 3, 6, 61, 62 is provided. Here, one member 62 is a circuit board, e.g. a PCB, mounted on the resin body 61 and laterally overlapping with the power semiconductor device 3. The member 62 may be a control board and may comprise control devices.

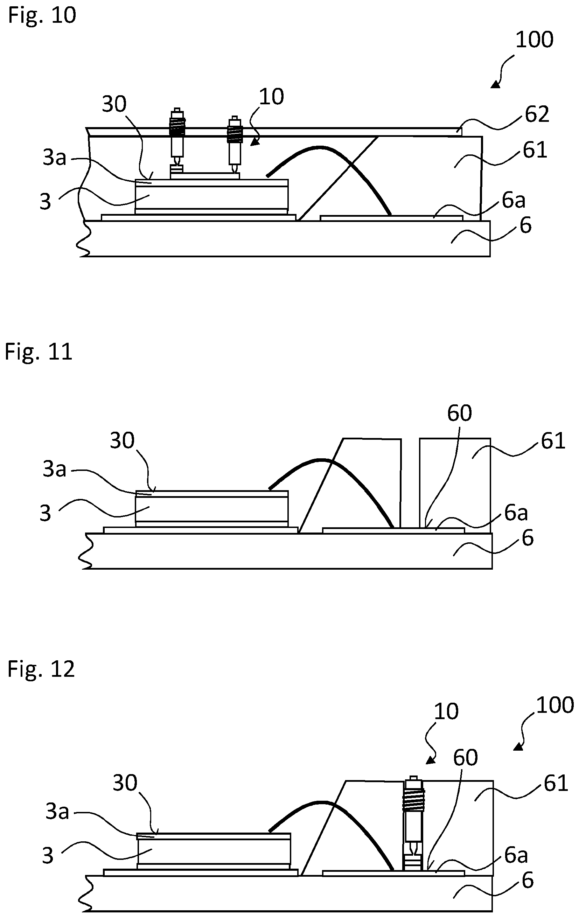

In figure 10, the sensor unit 10 of figure 8 is mounted again with the sensor element 1 being placed on the measurement surface 30 of the power semiconductor device 3. The contact elements 2 of the sensor unit 10 are screwed into threaded holes of the circuit board 62, are thereby mechanically fixed to the circuit board 62 and at the same time are mechanically biased so that the sensor element 1 is pressed against the measurement surface 30.

Figure 10 shows a further exemplary embodiment of an electronic device 100 in the form of a power semiconductor module 100. In this case, both contact elements 2 of the sensor unit 10 project out of the circuit board in vertical direction so that terminal regions of both contact elements 2 are exposed at the top side of the power semiconductor module 100. These terminal regions of the two contact elements 2 can be electrically connected for read-out of the sensor element 1.

Figure 11 shows a position in which an assembly of a substrate 6, a power semiconductor device 3 and a resin body 61 are provided. A hole is formed in the resin body 61 above the top metallization 6a. In this case, the top metallization 6a forms a measurement surface 60 at which a physical quantity, for example the temperature, shall be measured.

In the position of figure 12, the sensor unit 10 of figure 5 is mounted by screwing it into the hole in the resin body 61 so that the sensor element 1 is again placed on the measurement surface 60. For enabling the screwing, the hole in the resin body 61 may comprise an inner thread. Alternatively, a nut with an inner thread may be embedded in the resin body (not shown) .

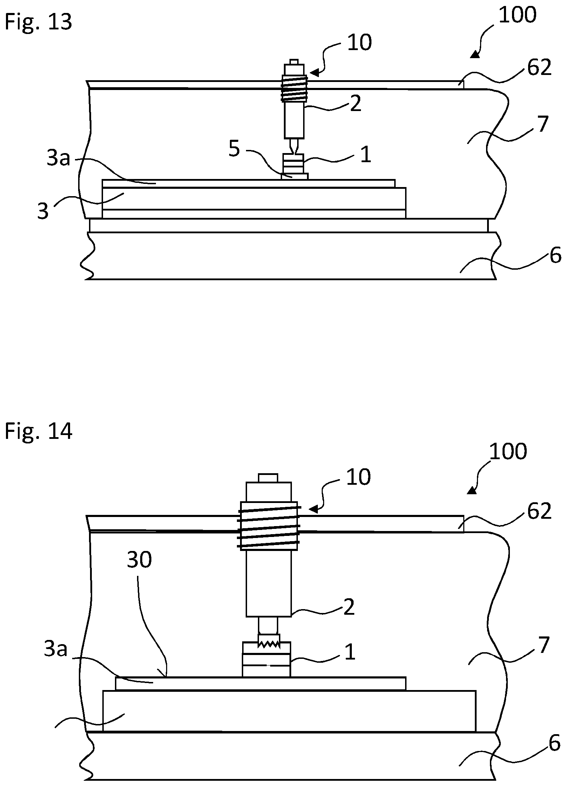

Figure 13 shows an example of the electronic device 100 being a power semiconductor module 100. In this case, a thermally conductive material 5, e.g. in the form of a paste filled with electrically and/or thermally conductive particles, like metal particles, or a flexible material sheet is arranged between the sensor element 1 and the top electrode 3a. A dry electrical contact may be formed between the material 5 and the sensor element 1 and/or between the material 5 and the top electrode 3a.

In the case of figure 13, the thermally conductive material 5 is also electrically conductive in order to establish an electrical contact between the top electrode 3a and the sensor element 1. If such a thermally conductive material 5 would be used in the exemplary embodiment of figure 10, the material 5 could be electrically isolating, for example.

The electronic device 100 is not in accordance with the claimed invention as long as it does not comprise a resin body which maintains the biased state of the contact element 2 in accordance with claim 1.

In the example of the electronic device 100 of figure 14, the bottom side of the sensor element 1, namely the bottom electrode 1a, comprises a roughening with a plurality of protrusions and recesses. The average roughness of this roughening is, for example, at least 1.6 µm. When the sensor element 1 is pressed against the measurement surface 30 by means of the biased contact element 2, the protrusions may imprint into the measurement surface 30 and thereby improve the dry electrical contact, e.g. by penetrating and/or locally destroying an occurring oxide layer. For this purpose, the measurement surface 60 may be comparably soft compared to the material of the roughened surface.

The electronic device 100 is not in accordance with the claimed invention as long as it does not comprise a resin body which maintains the biased state of the contact element 2 in accordance with claim 1.

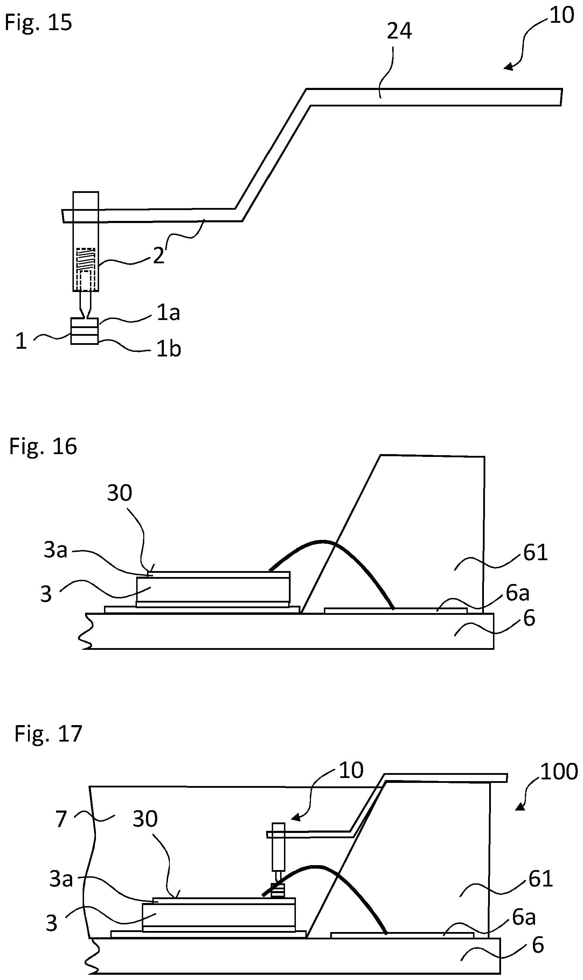

Figure 15 shows a position in which a further exemplary embodiment of the sensor unit 10 for an electronic device is provided. In this case, the contact element 2 comprises a press contact pin as described before and additionally a terminal structure 24 which is mechanically and electrically connected to the press contact pin. This connection may be established in different ways, for example by screwing, soldering, gluing, sintering, welding etc. The terminal structure 24 is a sheet-like element and may be formed of metal, e.g. Cu or Cu alloy.

In the position of figure 16, an assembly of different members for an electronic device 100 is again provided comprising a substrate 6, a power semiconductor device 3 and a resin body 61.

Figure 17 shows an exemplary embodiment of the electronic device 100 in the form of a power semiconductor module 100 which is produced, inter alia, by mounting the sensor unit 10 of figure 15 onto the assembly of figure 16. The auxiliary terminal structure 24 is, for example, glued to the resin body 61 so that the press contact pin is maintained in its biased state. In figure 17, the power semiconductor device 3 and part of the sensor unit 10 is embedded into a casting 7 in the form of a gel, for example. The terminal structure 24 constitutes an auxiliary terminal of the power semiconductor module 100.

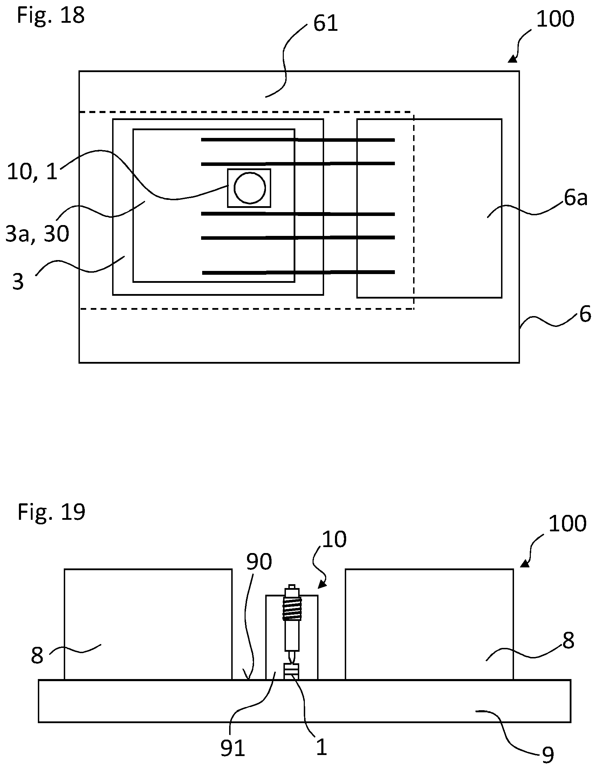

Figure 18 shows an exemplary embodiment of the electronic device 100 in top view onto the measurement surface 30. As can be seen here, the sensor element 1 is placed on the measurement surface 30 laterally between two adjacent bond wires, wherein the two adjacent bond wires are both electrically and mechanically connected to the top electrode 3a of the power semiconductor device 3.

Figure 19 shows an exemplary embodiment of an electronic device 100 in the form of an assembly of two power semiconductor modules 8 mounted on a cooler 9. The cooler 9 is configured for cooling the power semiconductor modules 8. For example, the cooler 9 comprises a channel for guiding a cooling liquid through the cooler 9. The cooler 9 is, for example, formed of metal, like Cu or Al. An exposed surface of the cooler 9 is used as a measurement surface 90. A nut 91 with an inner thread is mounted on the measurement surface 90. The sensor unit 10 of figure 5 is screwed into the nut 91 so that the sensor element 1 is placed on the measurement surface 90 and so that the contact element 2 is fixed to the nut 91 in its biased state.

Instead of the cooler 9 forming the measurement surface, also a baseplate of a power semiconductor module may form the measurement surface.

### Reference Signs

- 1: sensor element
- 1a: top electrode
- 1b: bottom electrode
- 2: contact element
- 3: power semiconductor device
- 3a: top electrode
- 4: auxiliary terminal (structure)
- 5: thermally conductive material
- 6: substrate
- 6a: top metallization
- 7: casting/gel
- 8: power semiconductor module
- 9: cooler
- 10: sensor unit for an electronic device
- 21: means for threaded connections
- 22: spring
- 24: auxiliary terminal structure
- 30: measurement surface
- 41: means for threaded connection
- 60: measurement surface
- 61: resin/resin body/housing frame
- 62: circuit board
- 90: measurement surface
- 91: nut
- 100: electronic device

## Claims

1. Electronic device (100), comprising
- a sensor unit (10), the sensor unit (10) comprising
- a sensor element (1) for measuring a physical quantity in the electronic device (100),
- a contact element (2) comprising one or more deformable, elastic portions for bringing the contact element (2) in a mechanically biased state, wherein
- the contact element (2) is fixed to the sensor element (1) and electrically connected thereto,
wherein the electronic device (100) comprises a member (3, 6, 9) having a measurement surface (30, 60, 90) at which a physical quantity is to be measured with the help of the sensor element (1), wherein
- the sensor element (1) is placed on the measurement surface (30, 60, 90),
- the contact element (2) is mechanically biased in order to exert a force onto the sensor element (1) acting in the direction towards the measurement surface (30, 60, 90),
**characterized in that** the electronic device (100) comprises a resin body (61), wherein, to maintain the biased state,
- the contact element (2) is fixed to the resin body (61) or the contact element (2) is connected to an auxiliary terminal structure (4) or to a circuit board (62) which is fixed to the resin body (61).

2. The electronic device (100) according to claim 1, wherein
- the sensor element (1) is a temperature sensor.

3. The electronic device (100) according to claim 1 or 2, wherein
- the contact element (2) comprises means (21) for screwing the contact element (2) into a thread of the auxiliary terminal structure (4), into a thread of the circuit board (62), into a hole in the resin body (61) or into a nut with an inner thread embedded in the resin body (61) or the contact element (2) comprises a profiling or ribs at an outer surface embedded in the resin body (61) in order to form-fittingly fix the contact element (2) to the electronic device (100).

4. The electronic device of any of the preceding claims, wherein the contact element (2) or the auxiliary terminal structure (4) is partially embedded in the resin body (61).

5. The electronic device of any of claims 1 to 3,
wherein the circuit board (62) or the auxiliary terminal structure (4) is mounted on the resin body (61).

6. The electronic device (100) according to any one of the preceding claims,
wherein the contact element (2) comprises a main body, a tip element and one or more springs (22), wherein the tip element is movably mounted with respect to the main body and can be moved towards or further into the main body by compressing the one or more springs (22).

7. The electronic device (100) according to any one of the preceding claims, wherein
- the sensor element (1) comprises a top electrode (1a) at a top side of the sensor element (1) and a bottom electrode (1b) at a bottom side of the sensor element (1) opposite to the top side,
- the contact element (2) is electrically connected and fixed to the top electrode (1a) of the sensor element (1),
- the bottom electrode (1b) of the sensor element (1) is exposed in an unmounted configuration of the sensor unit (10).

8. The electronic device (100) according to any of the preceding claims, comprising
- a power semiconductor device (3), wherein
- the sensor element (1) is placed on the power semiconductor device (3).

9. The electronic device (100) according to claim 8, wherein
- the measurement surface (30) is formed by a top electrode (3a) of the power semiconductor device (3),
- the sensor unit (10) is the sensor unit (10) according to claim 7,
- the bottom electrode (1b) of the sensor element (1) is in dry electrical contact with the top electrode (3a) of the power semiconductor device (3).

10. The electronic device (100) according to any one of the preceding claims, wherein
- a thermally conductive material (5) is arranged between the measurement surface (30, 60, 90) and the sensor element (1)
- the thermally conductive material (5) comprises a paste filled with electrically conductive particles.

11. The electronic device (100) according to any one of the preceding claims, comprising
- at least one power semiconductor module (8) and a cooler (9) for the at least one power semiconductor module (8),
- the measurement surface (90) is formed by the cooler (9).

12. The electronic device (100) according to any one of the preceding claims, wherein
- at least one of the measurement surface (30, 60 ,90) and the surface of the sensor element (1) facing the measurement surface (30, 60, 90) is roughened in order to increase the contact surface,
- the roughed surface has an average roughness of at least 1.6 µm.

13. Method for mounting a sensor element, comprising
- providing a sensor unit (10), the sensor unit (10) comprising
- a sensor element (1) for measuring a physical quantity in an electronic device (100),
- a contact element (2) comprising one or more deformable, elastic portions for bringing the contact element (2) in a mechanically biased state, wherein
- the contact element (2) is fixed to the sensor element (1) and electrically connected thereto,
- providing a member (3, 6, 9) for the electronic device (100) having a measurement surface (30, 60, 90) at which a physical quantity of the electronic device (100) is to be measured with the help of the sensor element (1),
- mounting the sensor unit (10) to the member (3, 6, 9), wherein mounting comprises
- placing the sensor element (1) onto the measurement surface (30, 60, 90),
- mechanically biasing the contact element (2) in such a way that it exerts a force onto the sensor element (1) acting in the direction towards the measurement surface (30, 60, 90) and
- fixing at least a portion of the mechanically biased contact element (2) with respect to the member (3, 6, 9) so that the contact element (2) remains in the mechanically biased state,
**characterized in that** the electronic device (100) comprises a resin body (61), wherein, to maintain the biased state,
- the contact element (2) is fixed to the resin body (61) or the contact element (2) is connected to an auxiliary terminal structure (4) or to a circuit board (62) which is fixed to the resin body (61).

14. Method according to claim 13, wherein
- fixing at least a portion of the mechanically biased contact element (2) with respect to the member (3, 6, 9) comprises screwing the contact element (2) into a thread of the auxiliary terminal structure (4) or into a thread of the circuit board (62) or into a hole in the resin body (61) or into a nut with an inner thread embedded in the resin body (61) or at least partly embedding the contact element (2) into the resin body (62).

## Patentansprüche

1. Elektronische Vorrichtung (100), aufweisend:
- eine Sensoreinheit (10), wobei die Sensoreinheit (10) Folgendes aufweist:
- ein Sensorelement (1) zum Messen einer physikalischen Größe in der elektronischen Vorrichtung (100),
- ein Kontaktelement (2), das einen oder mehrere verformbare, elastische Abschnitte aufweist, um das Kontaktelement (2) in einen mechanisch vorgespannten Zustand zu bringen, wobei
- das Kontaktelement (2) am Sensorelement (1) befestigt und mit diesem elektrisch verbunden ist,
wobei die elektronische Vorrichtung (100) ein Element (3, 6, 9) mit einer Messfläche (30, 60, 90) aufweist, an der eine physikalische Größe mithilfe des Sensorelements (1) gemessen werden soll, wobei
- das Sensorelement (1) auf der Messfläche (30, 60, 90) platziert ist,
- das Kontaktelement (2) mechanisch vorgespannt ist, um eine in Richtung der Messfläche (30, 60, 90) wirkende Kraft auf das Sensorelement (1) auszuüben,
**dadurch gekennzeichnet, dass**
die elektronische Vorrichtung (100) einen Harzkörper (61) aufweist, wobei, um den vorgespannten Zustand beizubehalten,
- das Kontaktelement (2) am Harzkörper (61) befestigt ist oder das Kontaktelement (2) mit einer Hilfsanschlussstruktur (4) oder mit einer Leiterplatte (62), die am Harzkörper (61) befestigt ist, verbunden ist.

2. Elektronische Vorrichtung (100) nach Anspruch 1, wobei
- das Sensorelement (1) ein Temperatursensor ist.

3. Elektronische Vorrichtung (100) nach Anspruch 1 oder 2, wobei
- das Kontaktelement (2) Mittel (21) zum Einschrauben des Kontaktelements (2) in ein Gewinde der Hilfsanschlussstruktur (4), in ein Gewinde der Leiterplatte (62), in ein Loch im Harzkörper (61) oder in eine im Harzkörper (61) eingebettete Mutter mit einem Innengewinde aufweist,
oder das Kontaktelement (2) an einer im Harzkörper (61) eingebetteten Außenfläche eine Profilierung oder Rippen aufweist, um das Kontaktelement (2) formschlüssig an der elektronischen Vorrichtung (100) zu befestigen.

4. Elektronische Vorrichtung nach einem der vorhergehenden Ansprüche,
wobei das Kontaktelement (2) oder die Hilfsanschlussstruktur (4) teilweise im Harzkörper (61) eingebettet ist.

5. Elektronische Vorrichtung nach einem der Ansprüche 1 bis 3,
wobei die Leiterplatte (62) oder die Hilfsanschlussstruktur (4) auf dem Harzkörper (61) montiert ist.

6. Elektronische Vorrichtung (100) nach einem der vorhergehenden Ansprüche,
wobei das Kontaktelement (2) einen Hauptkörper, eine Kontaktspitze und eine oder mehrere Federn (22) aufweist, wobei die Kontaktspitze in Bezug auf den Hauptkörper beweglich montiert ist und durch Zusammendrücken der einen oder mehreren Federn (22) zum Hauptkörper hin oder weiter in diesen hinein bewegt werden kann.

7. Elektronische Vorrichtung (100) nach einem der vorhergehenden Ansprüche, wobei
- das Sensorelement (1) eine obere Elektrode (1a) an einer Oberseite des Sensorelements (1) und eine untere Elektrode (1b) an einer Unterseite des Sensorelements (1) gegenüber der Oberseite aufweist,
- das Kontaktelement (2) mit der oberen Elektrode (1a) des Sensorelements (1) elektrisch verbunden und daran befestigt ist,
- die untere Elektrode (1b) des Sensorelements (1) in einer nicht montierten Konfiguration der Sensoreinheit (10) freiliegt.

8. Elektronische Vorrichtung (100) nach einem der vorhergehenden Ansprüche, aufweisend:
- eine Leistungshalbleitervorrichtung (3), wobei
- das Sensorelement (1) auf der Leistungshalbleitervorrichtung (3) platziert ist.

9. Elektronische Vorrichtung (100) nach Anspruch 8, wobei
- die Messfläche (30) durch eine obere Elektrode (3a) der Leistungshalbleitervorrichtung (3) gebildet wird,
- die Sensoreinheit (10) die Sensoreinheit (10) nach Anspruch 7 ist,
- die untere Elektrode (1b) des Sensorelements (1) in trockenem elektrischem Kontakt mit der oberen Elektrode (3a) der Leistungshalbleitervorrichtung (3) steht.

10. Elektronische Vorrichtung (100) nach einem der vorhergehenden Ansprüche, wobei
- zwischen der Messfläche (30, 60, 90) und dem Sensorelement (1) ein wärmeleitendes Material (5) angeordnet ist,
- das wärmeleitende Material (5) eine Paste aufweist, die mit elektrisch leitenden Partikeln gefüllt ist.

11. Elektronische Vorrichtung (100) nach einem der vorhergehenden Ansprüche, aufweisend:
- mindestens ein Leistungshalbleitermodul (8) und einen Kühler (9) für das mindestens eine Leistungshalbleitermodul (8),
- wobei die Messfläche (90) durch den Kühler (9) gebildet wird.

12. Elektronische Vorrichtung (100) nach einem der vorhergehenden Ansprüche, wobei
- die Messfläche (30, 60, 90) und/oder die der Messfläche (30, 60, 90) zugewandte Fläche des Sensorelements (1) aufgeraut ist, um die Kontaktfläche zu vergrößern,
- die aufgeraute Fläche einen Mittenrauwert von mindestens 1,6 µm aufweist.

13. Verfahren zum Montieren eines Sensorelements, aufweisend:
- Bereitstellen einer Sensoreinheit (10), wobei die Sensoreinheit (10) Folgendes aufweist:
- ein Sensorelement (1) zum Messen einer physikalischen Größe in einer elektronischen Vorrichtung (100),
- ein Kontaktelement (2), das einen oder mehrere verformbare, elastische Abschnitte aufweist, um das Kontaktelement (2) in einen mechanisch vorgespannten Zustand zu bringen, wobei
- das Kontaktelement (2) am Sensorelement (1) befestigt und mit diesem elektrisch verbunden ist,
- Bereitstellen eines Elements (3, 6, 9) für die elektronische Vorrichtung (100), das eine Messfläche (30, 60, 90) aufweist, an der eine physikalische Größe der elektronischen Vorrichtung (100) mithilfe des Sensorelements (1) gemessen werden soll,
- Montieren der Sensoreinheit (10) an dem Element (3, 6, 9), wobei das Montieren Folgendes umfasst:
- Platzieren des Sensorelements (1) auf der Messfläche (30, 60, 90),
- mechanisches Vorspannen des Kontaktelements (2) derart, dass es eine in Richtung der Messfläche (30, 60, 90) wirkende Kraft auf das Sensorelement (1) ausübt und
- Befestigen mindestens eines Abschnitts des mechanisch vorgespannten Kontaktelements (2) bezüglich des Elements (3, 6, 9), sodass das Kontaktelement (2) in dem mechanisch vorgespannten Zustand bleibt,
**dadurch gekennzeichnet, dass**
die elektronische Vorrichtung (100) einen Harzkörper (61) aufweist, wobei, um den vorgespannten Zustand beizubehalten,
- das Kontaktelement (2) am Harzkörper (61) befestigt ist oder das Kontaktelement (2) mit einer Hilfsanschlussstruktur (4) oder mit einer Leiterplatte (62), die am Harzkörper (61) befestigt ist, verbunden ist.

14. Verfahren nach Anspruch 13, wobei
- das Befestigen mindestens eines Abschnitts des mechanisch vorgespannten Kontaktelements (2) in Bezug auf das Element (3, 6, 9) das Einschrauben des Kontaktelements (2) in ein Gewinde der Hilfsanschlussstruktur (4) oder in ein Gewinde der Leiterplatte (62) oder in ein Loch in dem Harzkörper (61) oder in eine im Harzkörper (61) eingebettete Mutter mit einem Innengewinde oder zumindest teilweises Einbetten des Kontaktelements (2) in den Harzkörper (62) umfasst.

## Revendications

1. Dispositif électronique (100), comprenant
- une unité capteur (10), l'unité capteur (10) comprenant
- un élément capteur (1) destiné à mesurer une grandeur physique dans le dispositif électronique (100),
- un élément de contact (2) comprenant une ou plusieurs portions élastiques déformables destinées à amener l'élément de contact (2) dans un état mécaniquement sollicité,
- l'élément de contact (2) étant fixé à l'élément capteur (1) et relié électriquement à celui-ci,
le dispositif électronique (100) comprenant un organe (3, 6, 9) présentant une surface de mesure (30, 60, 90) au niveau de laquelle une grandeur physique doit être mesurée à l'aide de l'élément capteur (1),
- l'élément capteur (1) étant mis en place sur la surface de mesure (30, 60, 90),
- l'élément de contact (2) étant sollicité mécaniquement dans le but d'exercer sur l'élément capteur (1) une force agissant en direction de la surface de mesure (30, 60, 90),
**caractérisé en ce que**
le dispositif électronique (100) comprend un corps en résine (61) ; aux fins de maintenir l'état sollicité,
- l'élément de contact (2) étant fixé au corps en résine (61) ou l'élément de contact (2) étant relié à une structure formant borne auxiliaire (4) ou à une carte de circuit imprimé (62) qui est fixée au corps en résine (61).

2. Dispositif électronique (100) selon la revendication 1, dans lequel
- l'élément capteur (1) est un capteur de température.

3. Dispositif électronique (100) selon la revendication 1 ou 2, dans lequel
- l'élément de contact (2) comprend des moyens (21) permettant de visser l'élément de contact (2) dans un filetage de la structure formant borne auxiliaire (4), dans un filetage de la carte de circuit imprimé (62), dans un trou ménagé dans le corps en résine (61) ou dans un écrou à filetage intérieur noyé dans le corps en résine (61)
ou l'élément de contact (2) comprend un profilage ou des nervures au niveau d'une surface extérieure noyés dans le corps en résine (61) dans le but de fixer l'élément de contact (2) au dispositif électronique (100) par complémentarité de forme.

4. Dispositif électronique selon l'une quelconque des revendications précédentes,
dans lequel l'élément de contact (2) ou la structure formant borne auxiliaire (4) est partiellement noyé ou noyée dans le corps en résine (61).

5. Dispositif électronique selon l'une quelconque des revendications 1 à 3,
dans lequel la carte de circuit imprimé (62) ou la structure formant borne auxiliaire (4) est montée sur le corps en résine (61).

6. Dispositif électronique (100) selon l'une quelconque des revendications précédentes,
dans lequel l'élément de contact (2) comprend un corps principal, un élément d'extrémité et un ou plusieurs ressorts (22), l'élément d'extrémité étant monté mobile par rapport au corps principal et pouvant être déplacé vers le corps principal ou davantage à l'intérieur de celui-ci par compression du ou des ressorts (22).

7. Dispositif électronique (100) selon l'une quelconque des revendications précédentes, dans lequel
- l'élément capteur (1) comprend une électrode supérieure (1a) au niveau d'une face supérieure de l'élément capteur (1) et une électrode inférieure (1b) au niveau d'une face inférieure de l'élément capteur (1) opposée à la face supérieure,
- l'élément de contact (2) est relié électriquement à l'électrode supérieure (1a) de l'élément capteur (1) et fixé à celle-ci,
- l'électrode inférieure (1b) de l'élément capteur (1) est à découvert dans une configuration non montée de l'unité capteur (10).

8. Dispositif électronique (100) selon l'une quelconque des revendications précédentes, comprenant
- un dispositif à semi-conducteur de puissance (3),
- l'élément capteur (1) étant mis en place sur le dispositif à semi-conducteur de puissance (3).

9. Dispositif électronique (100) selon la revendication 8, dans lequel
- la surface de mesure (30) est formée par une électrode supérieure (3a) du dispositif à semi-conducteur de puissance (3),
- l'unité capteur (10) est l'unité capteur (10) selon la revendication 7,
- l'électrode inférieure (1b) de l'élément capteur (1) est en contact électrique sec avec l'électrode supérieure (3a) du dispositif à semi-conducteur de puissance (3).

10. Dispositif électronique (100) selon l'une quelconque des revendications précédentes, dans lequel
- un matériau thermiquement conducteur (5) est agencé entre la surface de mesure (30, 60, 90) et l'élément capteur (1)
- le matériau thermiquement conducteur (5) comprend une pâte chargée de particules électriquement conductrices.

11. Dispositif électronique (100) selon l'une quelconque des revendications précédentes, comprenant
- au moins un module à semi-conducteur de puissance (8) et un refroidisseur (9) destiné à l'au moins un module à semi-conducteur de puissance (8),
- la surface de mesure (90) étant formée par le refroidisseur (9).

12. Dispositif électronique (100) selon l'une quelconque des revendications précédentes, dans lequel
- au moins une surface parmi la surface de mesure (30, 60, 90) et la surface de l'élément capteur (1) en regard de la surface de mesure (30, 60, 90) est rendue rugueuse dans le but d'augmenter la surface de contact,
- la surface rugueuse présente une rugosité moyenne d'au moins 1,6 µm.

13. Procédé de montage d'un élément capteur, comprenant
- la fourniture d'une unité capteur (10), l'unité capteur (10) comprenant
- un élément capteur (1) destiné à mesurer une grandeur physique dans un dispositif électronique (100),
- un élément de contact (2) comprenant une ou plusieurs portions élastiques déformables destinées à amener l'élément de contact (2) dans un état mécaniquement sollicité,
- l'élément de contact (2) étant fixé à l'élément capteur (1) et relié électriquement à celui-ci,
- la fourniture d'un organe (3, 6, 9) destiné au dispositif électronique (100), présentant une surface de mesure (30, 60, 90) au niveau de laquelle une grandeur physique du dispositif électronique (100) doit être mesurée à l'aide de l'élément capteur (1),
- le montage de l'unité capteur (10) sur l'organe (3, 6, 9), le montage comprenant
- la mise en place de l'élément capteur (1) sur la surface de mesure (30, 60, 90),
- la sollicitation mécanique de l'élément de contact (2) de telle manière qu'il exerce sur l'élément capteur (1) une force agissant en direction de la surface de mesure (30, 60, 90) et
- la fixation d'au moins une portion de l'élément de contact (2) mécaniquement sollicité par rapport à l'organe (3, 6, 9) de sorte que l'élément de contact (2) reste dans l'état mécaniquement sollicité,
**caractérisé en ce que**
le dispositif électronique (100) comprend un corps en résine (61) ; aux fins de maintenir l'état sollicité,
- l'élément de contact (2) étant fixé au corps en résine (61) ou l'élément de contact (2) étant relié à une structure formant borne auxiliaire (4) ou à une carte de circuit imprimé (62) qui est fixée au corps en résine (61).

14. Procédé selon la revendication 13, dans lequel
- la fixation d'au moins une portion de l'élément de contact (2) mécaniquement sollicité par rapport à l'organe (3, 6, 9) comprend le vissage de l'élément de contact (2) dans un filetage de la structure formant borne auxiliaire (4) ou dans un filetage de la carte de circuit imprimé (62) ou dans un trou ménagé dans le corps en résine (61) ou dans un écrou à filetage intérieur noyé dans le corps en résine (61), ou le noyage au moins partiel de l'élément de contact (2) dans le corps en résine (62).
